(19) Europäisches Patentamt
European Patent Office
Office européen des brevets

(11) **EP 4 040 345 A1**

(12) **EUROPEAN PATENT APPLICATION**
published in accordance with Art. 153(4) EPC

(43) Date of publication:
**10.08.2022 Bulletin 2022/32**

(21) Application number: **20873125.7**

(22) Date of filing: **29.09.2020**

(51) International Patent Classification (IPC):
**G06N 20/00** *(2019.01)*

(52) Cooperative Patent Classification (CPC):
**G06N 20/00**

(86) International application number:
**PCT/JP2020/037029**

(87) International publication number:
**WO 2021/065962 (08.04.2021 Gazette 2021/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **04.10.2019 JP 2019184139**

(71) Applicant: **NTT Communications Corporation
Tokyo 100-8019 (JP)**

(72) Inventors:
• **OKAWACHI, Tomomi**
  **Tokyo 100-8019 (JP)**
• **IZUMITANI, Tomonori**
  **Tokyo 100-8019 (JP)**
• **KIRITOSHI, Keisuke**
  **Tokyo 100-8019 (JP)**
• **KOYAMA, Kazuki**
  **Tokyo 100-8019 (JP)**

(74) Representative: **Hoffmann Eitle
Patent- und Rechtsanwälte PartmbB
Arabellastraße 30
81925 München (DE)**

(54) **INFORMATION PROCESSING DEVICE, INFORMATION PROCESSING METHOD, AND INFORMATION PROCESSING PROGRAM**

(57)    An information processing device (10) includes: an acquisition unit (12a) configured to acquire a plurality of pieces of data; an importance extraction unit (12c) configured to input the pieces of data to a model as input data, and in a case of obtaining output data output from the model, calculate an importance of each component of the input data with respect to the output data based on the input data and the output data; a coefficient acquisition unit (12d) configured to acquire a binding coefficient indicating a relevance among components of the input data; a binding unit (12e) configured to calculate a bound importance obtained by applying the binding coefficient to the importance; and a visualization unit (12f) configured to create information indicating the bound importance of each input item.

FIG.1

**Description**

[Technical Field]

The present invention relates to an information processing device, an information processing method, and an information processing program.

[Background Art]

Deep learning has initially attracted attention by achieving high discrimination performance that is close to human beings or superior to human beings in a field of image processing. At the present time, usefulness of deep learning is confirmed in subjects of dealing with a wide variety of data including typical time series data such as sensor data in addition to moving image processing and voice/language processing. Thus, demonstration experiments have been planned by using data collected from actual facilities in a manufacturing industry including a chemical industry, and have produced certain results in subjects such as quality prediction or anomaly detection in a system.

Presently, at the time of introducing a model of machine learning including deep learning into actual facilities, it is often examined whether there is certain validity in a relation between an input and an output learned by the model from a scientific/technological viewpoint, or whether the relation agrees with experience knowledge of human beings that have conventionally observed manufacturing processes thereof, for example. On the other hand, many of models of machine learning attracting attention in recent years represented by deep learning have a complicated structure, and it is difficult for human beings to intuitively understand the relation between an input and an output of the model or processing of the model for an individual input, and the model is often called a "black box".

Thus, interpretation of models of machine learning has been researched from an early age mainly in a field of image processing (for example, refer to Non Patent Documents 1 to 3), and a method in such a field of image processing that is simply expanded has been used for a model of deep learning for dealing with time series data.

For example, the technique disclosed in Patent Document 1 uses a sensitivity map for displaying an importance of an input component in a machine learning model used for monitoring a production process. Furthermore, the technique disclosed in Patent Document 1 supports monitoring processing by calculating an importance for individual pieces of input data, the importance indicating that which of characteristic amounts contributes to determination of a model. In addition, the technique disclosed in Non Patent Document 4 smoothes calculated importances by using a method obtained by getting an idea from SmoothGrad as one type of an explanation method in image processing for grasping a temporal change in the importances of respective input sensors in a soft sensor using a model of deep learning.

[Citation List]

[Non Patent Citation]

Non Patent Document 1: D. Baehrens, T. Schroeter, S. Harmeling, M. Kawanabe, K. Hansen, and K. Muller, "How to Explain Individual Classification Decisions", Journal of Machine Learning Research 11, 1803-1831. (2010).
Non Patent Document 2: D. Smilkov, N. Thorat, B. Kim, F. Viegas, and M. Wattenberg, "SmoothGrad: removing noise by adding noise", arXiv preprint, arXiv 1706. 03825. (2017).
Non Patent Document 3: M. Sundararajan, A. Taly, and Q. Yan, "Axiomatic Attribution for Deep Networks", ICML 2017.
Non Patent Document 4: Kiritoshi, Izumitani (2019). "Time-Smoothgrad: A Method Extracting Time-Varying Attribution for Neural Networks", JSAI 2019.

[Patent Citation]

Patent Document 1: Japanese Laid-open Patent Publication No. 2019-67139

[Summary of Invention]

[Technical Problem]

In the techniques disclosed in Patent Document 1 and Non Patent Document 4, an importance of each input component of a model is obtained while considering a one-to-one relation between each input component of the model and each output value of the model. That is, in a case of using sensor data as an input, the importance of each input component of the model is obtained while considering a one-to-one relation between each sensor value and the output value of the model at each time. The model is, for example, an estimation model that has performed learning in advance.

In a case of using a gradient of the input as the importance, when only a value of a sensor A ten minutes before the present time slightly varies, a degree of variation in an estimated value of a soft sensor as an output is assumed to be the importance of the value of the sensor A ten minutes before the present time.

This assumption is unnatural especially in a case of using time series data as an input for the model. For example, in a real system, when a value that is measured by the sensor A ten minutes before the present time is caused to slightly vary, it can be considered that a value that is measured by the sensor A after that time will also slightly vary. It can be considered that a value that is measured at the same time or after that time by another sensor B will also vary in conjunction with a slight variation in the sensor A.

However, in the related art, a correlation and a causal relation among input components of the model are scarcely considered in calculating the importance of each input component of the model.

For example, the following exemplifies a case of using, as an input, sensor data of a manufacturing industry such as a chemical industry. A monitor who observes a real system may empirically know that "when a value measured by the sensor A is operated, a value that should be estimated by the soft sensor ten minutes later will vary", or may grasp a correlative characteristic such that "the value that should be estimated by the soft sensor tends to be linked with a value of the sensor B five minutes before".

On the other hand, in a model of deep learning, each input component is automatically processed, or automatically picked and chosen to be useful for estimation. Due to this, even if the model appropriately grasps an input/output relation of the real system, the monitor cannot immediately recognize that the obtained importance agrees with an experience of the monitor related to the correlation and the causal relation among the input components, so that the monitor needs to examine a relation between the importance and experience knowledge of himself/herself again in many cases.

The same problem has arisen in a case of actually introducing such importance display systems into a monitoring system of a production process. For example, in the related art, when high importances are assigned to only part of some input components that vary in conjunction with each other in a real system, the monitor cannot recognize the relation among the input components in some cases. In a case in which the importance is assigned to an input component that cannot be operated in a production process, the monitor cannot grasp influence of an input component that can be operated in the production process on an estimated value, and various devices are difficult to be operated in the production process in some cases. Thus, in the related art, an effect of the importance is extremely limited in some cases.

[Solution to Problem]

In order to solve the above-described problems and achieve the object, an information processing device according to the present invention includes: an acquisition unit configured to acquire a plurality of pieces of data; a first importance calculation unit configured to input the pieces of data to a model as input data, and in a case of obtaining output data output from the model, calculate an importance of each component of the input data with respect to the output data based on the input data and the output data; a coefficient acquisition unit configured to acquire a binding coefficient indicating a relevance among components of the input data; a second importance calculation unit configured to calculate a bound importance obtained by applying the binding coefficient to the importance; and a creation unit configured to create information indicating the bound importance of each input item.

An information processing method according to the present invention is an information processing method executed by an information processing device, and includes: a step of acquiring a plurality of pieces of data; a step of calculating by inputting the pieces of data to a model as input data, and in a case of obtaining output data output from the model, calculating an importance of each component of the input data with respect to the output data based on the input data and the output data; a step of acquiring a binding coefficient indicating a relevance among components of the input data; a step of calculating a bound importance obtained by applying the binding coefficient to the importance; and a step of creating information indicating the bound importance of each input item.

An information processing program according to the present invention causes a computer to execute: a step of acquiring a plurality of pieces of data; a step of calculating by inputting the pieces of data to a model as input data, and in a case of obtaining output data output from the model, calculating an importance of each component of the input data with respect to the output data based on the input data and the output data; a step of acquiring a binding coefficient indicating a relevance among components of the input data; a step of calculating a bound importance obtained by applying the binding coefficient to the importance; and a step of creating information indicating the bound importance of each input item.

[Advantageous Effects of Invention]

According to the present invention, an importance of each of input components of a model can be obtained while considering a relevance among the input components of the model.

[Brief Description of Drawings]

FIG. 1 is a block diagram illustrating a configuration example of a learning device according to a first embodiment.
FIG. 2 is a diagram for explaining an outline of information processing performed by an information processing device illustrated in FIG. 1.
FIG. 3 is a diagram illustrating an example of a heat map image indicating distribution of bound importances.
FIG. 4 is a diagram for explaining dimension reduction.
FIG. 5 is a diagram for explaining an example of a causal relation among input/output variables.
FIG. 6 is a flowchart illustrating an example of a processing procedure of information processing according to the first embodiment.
FIG. 7 is a diagram exemplifying a relevance among components of input data.
FIG. 8 is a diagram exemplifying input/output of data of a pre-learned estimation model.
FIG. 9 is a block diagram illustrating a configuration example of an information processing device according to a modification of the first embodiment.
FIG. 10 is a diagram illustrating a computer that executes a computer program.

[Embodiments for Carrying Out the Invention]

The following describes embodiments of an information processing device, an information processing method, and an information processing program according to the present application in detail based on the drawings. The information processing device, the information processing method, and the information processing program according to the present application are not limited to the embodiments. Hereinafter, in a case of describing A that is a vector, a matrix, or a scalar as "^A", for example, "^A" is assumed to be equal to a "symbol obtained by writing "^" right above "A"". In a case of describing A that is a vector, a matrix, or a scalar as "~A", for example, "~A" is assumed to be equal to a "symbol obtained by writing "~" right above "A"".

First embodiment

The following embodiment describes a configuration of an information processing device 10 according to a first embodiment and a procedure of processing performed by the information processing device 10 in order, and lastly describes an effect of the first embodiment.

Configuration of information processing device

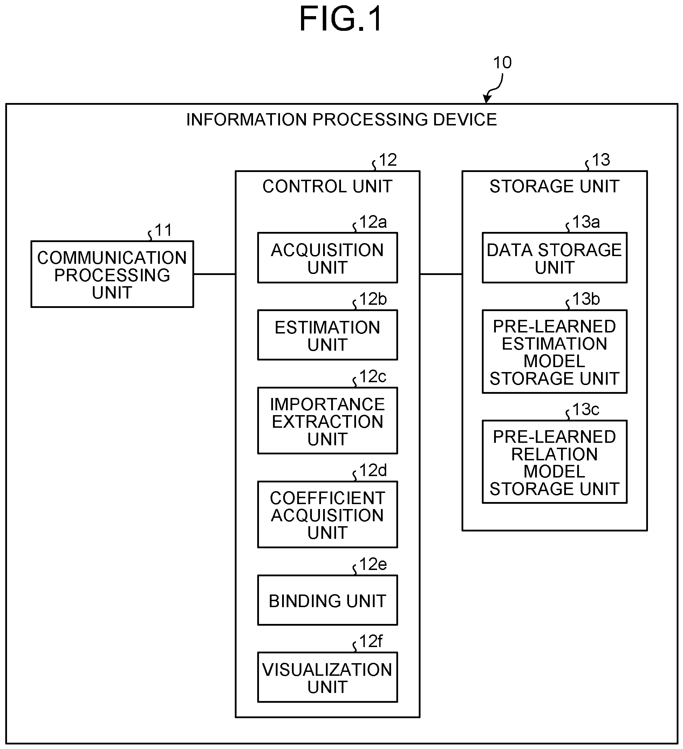

First, the following describes the configuration of the information processing device 10 with reference to FIG. 1. FIG. 1 is a block diagram illustrating a configuration example of the learning device according to the first embodiment.
Herein, for example, the information processing device 10 acquires a plurality of pieces of data acquired by a sensor installed in a facility to be monitored such as a factory or a plant. The information processing device 10 then uses the pieces of acquired data as inputs, and estimates a state of the facility to be monitored by using a pre-learned estimation model for estimating an anomaly in the facility to be monitored.
The information processing device 10 uses data of respective sensors input to the pre-learned estimation model and output data output from the pre-learned estimation model to calculate a contribution degree (importance) of each sensor to an output value. The importance indicates a degree of contribution of each input to an output. It is meant that, as an absolute value of the importance is larger, an influence degree of the input with respect to the output is higher. Herein, as the importance, the information processing device 10 obtains the importance of each input component with respect to a pre-learned model while considering a relevance among input components of the pre-learned estimation model. Specifically, the information processing device 10 acquires a binding coefficient indicating a relevance among components of input data of the pre-learned estimation model, and applies the binding coefficient to the importance to calculate and output the bound importance including the relevance among the input components of the pre-learned estimation model.
As a result, the monitor of the facility to be monitored can confirm the bound importance already including the relevance among the input components. Thus, the monitor does not necessarily examine a matching degree between the importance and an experience of the monitor himself/herself related to the correlation and the causal relation among the input components, the examination having been conventionally requested. In other words, the information processing device 10 outputs the bound importance already including the relation among the input components, so that a load of interpreting the bound importance on the monitor can be reduced.

As illustrated in FIG. 1, the information processing device 10 includes a communication processing unit 11, a control unit 12, and a storage unit 13. The following describes processing performed by each unit included in the information processing device 10.

The communication processing unit 11 controls communication related to various kinds of information exchanged with a connected device. For example, the communication processing unit 11 receives a plurality of pieces of data as processing targets from another device. Specifically, the communication processing unit 11 receives a plurality of pieces of sensor data acquired in the facility to be monitored. The communication processing unit 11 also transmits, to the other device, a state of the facility to be monitored estimated by the information processing device 10. The information processing device 10 may communicate with the other device via a communication network, or may operate in a local environment without being connected to the other device.

The storage unit 13 stores data and computer programs requested for various kinds of processing performed by the control unit 12 and includes a data storage unit 13a, a pre-learned estimation model storage unit 13b, and a pre-learned relation model storage unit 13c. For example, the storage unit 13 is a storage device such as a semiconductor memory element including a random access memory (RAM), a flash memory, and the like.

The data storage unit 13a stores data collected by an acquisition unit 12a described later. For example, the data storage unit 13a stores data from sensors disposed in target appliances in a factory, a plant, a building, a data center, and the like (for example, data such as a temperature, a pressure, sound, and vibration). The data storage unit 13a may store any type of data constituted of a plurality of real values such as image data, not limited to the data described above.

The pre-learned estimation model storage unit 13b stores the pre-learned estimation model (estimation model). The pre-learned estimation model is a model in which an input and an output are set corresponding to a problem to be solved. For example, the pre-learned estimation model is an estimation model for estimating an anomaly in the facility to be monitored. Specifically, the pre-learned estimation model is an estimation model for solving a problem for estimating a certain indicator for a certain product in a factory. In this case, the pre-learned estimation model is a model using sensor data within a certain time width acquired from a manufacturing process as input data, and outputting a value of an indicator at a time that is shifted, by a certain time, from an end time of the time width of the input data, the model that has been learned by using a method of statistics/machine learning.

Estimation means a procedure of estimating an unknown value by using a known value in a sense from a viewpoint of statistics/machine learning. Specific examples of this estimation model may include existing models such as a model that does not broadly consider a time-series property such as a simple linear multiple regression model or a model obtained by applying appropriate regularization thereto, a model that can be converted into a state space model that allows an exogenous variable such as a vector autoregressive model, or a model of various neural networks such as a feedforward type, a convolutional type, and a recurrent type, or deep learning performed by using a combination thereof.

The pre-learned relation model storage unit 13c stores the pre-learned relation model (relation model). The pre-learned relation model is a model that has learned a relevance among components of the input data with respect to the pre-learned estimation model. For example, the pre-learned relation model has learned a relevance among a plurality of pieces of sensor data in advance by using a method of statistics/machine learning based on the pieces of sensor data acquired on a time-series basis in the facility to be monitored. The pre-learned relation model uses the input data for the pre-learned estimation model as an input, and outputs a group of values of binding coefficients corresponding to respective input components of the input data. The binding coefficient is a coefficient indicating the relevance from a value of each component to a value of each component of the input data.

The control unit 12 includes an internal memory for storing requested data and computer programs specifying various processing procedures and executes various kinds of processing therewith. For example, the control unit 12 includes the acquisition unit 12a, an estimation unit 12b, an importance extraction unit 12c (a first importance calculation unit), a coefficient acquisition unit 12d, a binding unit 12e (a second importance calculation unit), and a visualization unit 12f (a creation unit). Herein, the control unit 12 is, for example, an electronic circuit such as a central processing unit (CPU), a micro processing unit (MPU), and a graphical processing unit (GPU), or an integrated circuit such as an application specific integrated circuit (ASIC) and a field programmable gate array (FPGA).

The acquisition unit 12a acquires a plurality of pieces of data. For example, the acquisition unit 12a acquires a plurality of pieces of sensor data acquired in the facility to be monitored. Specifically, the acquisition unit 12a periodically (for example, every minute) receives multivariate time-series numerical data from a sensor installed in the facility to be monitored such as a factory or a plant, and stores the data in the data storage unit 13a. Herein, the data acquired by the sensor is, for example, various kinds of data such as a temperature, a pressure, sound, and vibration related to a device or a reactor in the factory or a plant as the facility to be monitored. The data acquired by the acquisition unit 12a is not limited to the data acquired by the sensor but may be image data or numerical data input by a person, for example.

The estimation unit 12b inputs a plurality of pieces of data to the model as input data, and obtains output data (hereinafter, referred to as estimated output data) output from this model. The estimation unit 12b uses the pieces of sensor data acquired by the acquisition unit 12a as input data to be input to the pre-learned estimation model for estimating the state of the facility to be monitored, and obtains the estimated output data output from the pre-learned estimation model as an estimated value.

Specifically, the estimation unit 12b obtains, as the estimated output data, an estimated value related to the state of the facility to be monitored after a certain time set in advance elapses. For example, the estimation unit 12b obtains, as the estimated value, a presumed value of a specific sensor in the facility to be monitored. The estimation unit 12b may also calculate an abnormality degree from the presumed value that is output as described above. The estimated output data is output to the importance extraction unit 12c, and is visualized by the visualization unit 12f as part of an output from the information processing device 10.

The importance extraction unit 12c extracts the importance for output data of each component of the input data based on the input data and the output data output from the pre-learned estimation model. The importance extraction unit 12c calculates a group of values of importances for the output data of respective components of the input data by using one or more of the input data, the pre-learned estimation model, and the output data output from the pre-learned estimation model. For example, the importance extraction unit 12c inputs, as the input data, a plurality of pieces of the sensor data to the pre-learned estimation model for estimating the state of the facility to be monitored, and calculates the importance for each sensor based on the input data and the output data in a case of obtaining the output data output from the pre-learned estimation model. Hereinafter, the importance calculated by the importance extraction unit 12c is referred to as an input importance.

The following describes a specific example of calculating the input importance. For example, in the pre-learned model for calculating the output value from the input value, the importance extraction unit 12c uses a partial differential value related to each input value of the output value or an approximate value thereof to calculate the input importance for each sensor at each time. For example, the importance extraction unit 12c assumes the pre-learned estimation model as a function, and calculates the importance by using a method such as a sensitivity map, integrated gradients, Smooth-Grad, or Time-Smoothgrad using gradients in values of the input data. The importance extraction unit 12c may also calculate the importance by using a method of applying perturbation to the input data to calculate variation in the estimated output data, for example, a method of applying sufficiently small perturbation to each component of the input or a method of occlusion and the like.

The coefficient acquisition unit 12d acquires a binding coefficient indicating a relevance among the components of the input data of the pre-learned estimation model. The coefficient acquisition unit 12d acquires the binding coefficient by using the pre-learned relation model. The coefficient acquisition unit 12d inputs a value of each component of the input data to the pre-learned relation model, and acquires a group of values of binding coefficients indicating the relevance with respect to values of the respective components of the input data output from the pre-learned relation model.

The binding unit 12e calculates the bound importance by applying a corresponding binding coefficient to the input importance extracted by the importance extraction unit 12c. The binding unit 12e uses the group of values of the input importances and a group of values of the binding coefficients as inputs, assigns weight to each component of the input data by a value of a corresponding binding coefficient, and calculates a group of values obtained by adding up values of corresponding input importances, that is, a group of values of bound importances. The group of values of bound importances is part of the output from the information processing device 10.

The visualization unit 12f creates information indicating the estimated value estimated by the estimation unit 12b (for example, the abnormality degree), the bound importance calculated by the binding unit 12e, and the binding coefficient acquired by the coefficient acquisition unit 12d. For example, the visualization unit 12f creates and visualizes an image indicating the estimated value, the bound importance, and the binding coefficient.

For example, the visualization unit 12f displays the abnormality degree calculated by the estimation unit 12b as a chart screen. The visualization unit 12f also displays a graph indicating progression of the bound importance for each piece of the sensor data. The visualization unit 12f also obtains items having a relevance higher than a predetermined value among input items based on the binding coefficient, and creates information indicating the items in association with each other. For example, in the graph indicating the progression of the bound importance of each piece of the sensor data, the visualization unit 12f causes pieces of discrimination information of sensors having a relevance higher than the predetermined value to be framed, displayed with blinking, or displayed in the same color. Alternatively, the visualization unit 12f displays the fact that there are sensors having a relevance higher than the predetermined value, and the discrimination information of the sensors having the relevance. The visualization unit 12f may also create a heat map indicating distribution of the bound importances of the respective input items per unit time.

Procedure of information processing

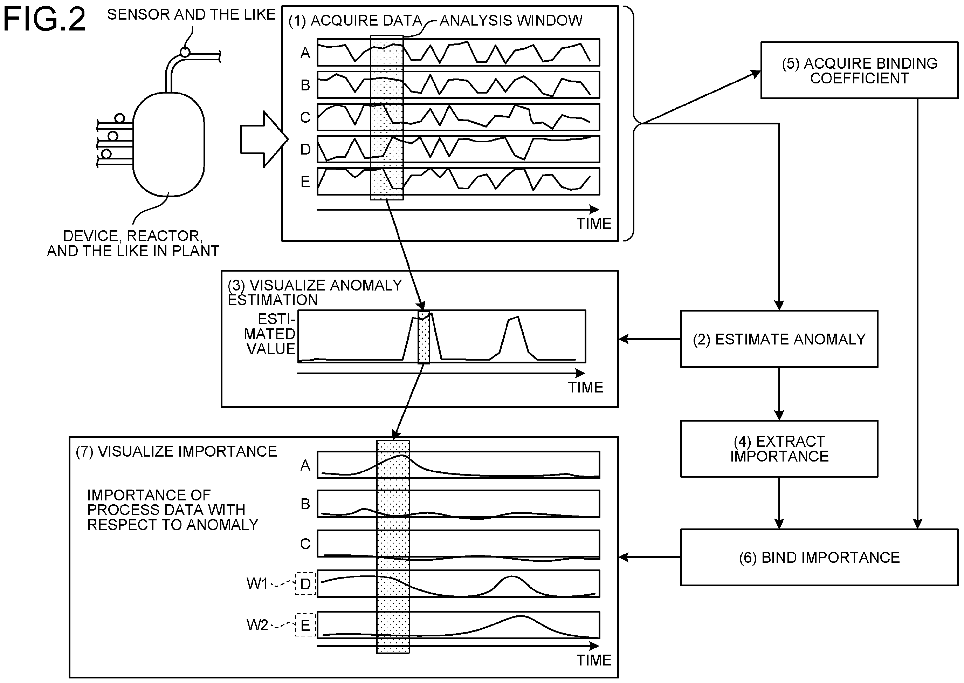

Next, the following describes an outline of information processing performed by the information processing device 10 with reference to FIG. 2. FIG. 2 is a diagram for explaining the outline of the information processing performed by the information processing device 10 illustrated in FIG. 1.

In FIG. 2, a sensor and a device for collecting signals for operation and the like are attached to a reactor or a device in a plant to acquire data at every fixed time. FIG. 2 (1) illustrates progression of process data collected by the acquisition unit 12a from the sensor A to a sensor E. The estimation unit 12b estimates an anomaly after a certain time elapses by using the pre-learned estimation model (refer to FIG. 2 (2)). The visualization unit 12f then outputs time series data of an estimated abnormality degree as a chart screen (refer to FIG. 2 (3)).

The importance extraction unit 12c extracts an input importance for a predetermined output value for each sensor at each time by using the process data input to the pre-learned estimation model and the output value from the pre-learned model (refer to FIG. 2 (4)). The coefficient acquisition unit 12d then inputs values of respective components of the process data to the pre-learned relation model, and acquires a group of values of binding coefficients indicating a relevance with respect to the value of each component (refer to FIG. 2 (5)). The binding unit 12e calculates the bound importance by applying a corresponding binding coefficient to the input importance extracted by the importance extraction unit 12c (refer to FIG. 2 (6)).

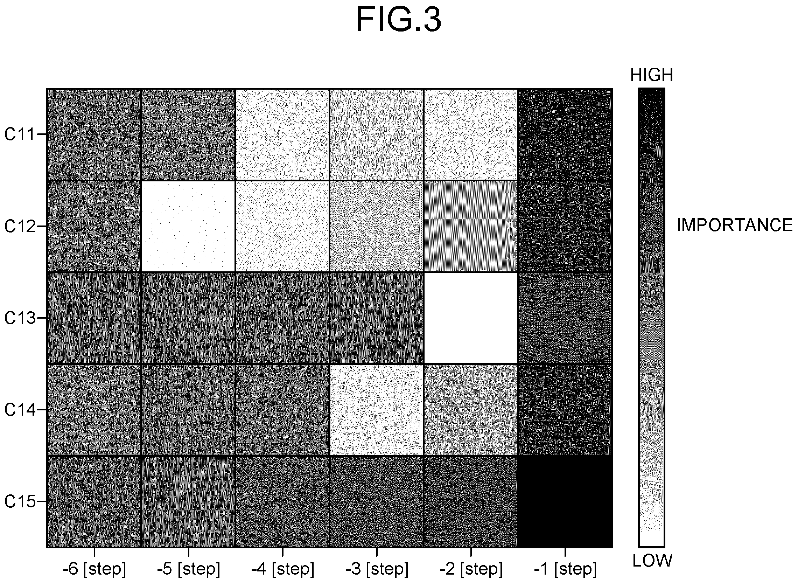

The visualization unit 12f then displays a chart screen indicating progression of the bound importance of the process data of each of the sensors A to E with respect to estimation (refer to FIG. 2 (7)). As illustrated in FIG. 2 (7), the visualization unit 12f may display sensors having a high relevance by surrounding, with frames W1 and W2, pieces of discrimination information "D" and "E" of the sensors D and E having a relevance higher than the predetermined value. In a case in which the relevance between the sensors is directed, the visualization unit 12f may display the fact that the relevance is directed, not limited to a case in which the relevance between the sensors is undirected. For example, in a case in which the sensor C -> the sensor D is higher than the predetermined value but the sensor D -> the sensor C is lower than the predetermined value, the visualization unit 12f may display text describing that fact. A display method for the sensors is merely an example, and is not limited to displaying with a frame or text. FIG. 3 is an example of a heat map image indicating distribution of the bound importances. As illustrated in FIG. 3, the visualization unit 12f may create and display a heat map indicating distribution of the bound importances of the respective input items.

Example of calculating binding coefficient

Next, the following describes an example of calculating the binding coefficient. It is assumed that the pre-learned estimation model is provided in advance. A pre-learned estimation model f (refer to Expression (1)) is a model that has learned a relation between an input $x = (x_1, ..., x_n) \in R^n$ and an output $y \in R$ from data in advance. It is assumed that estimated data $\hat{y} = f(x) \in R$.

$$f: x \mapsto \hat{y} \qquad (1)$$

Regarding estimation at the time of giving the input $x = (x_1, ..., x_n)$ to the model f, it is assumed that the importance extraction unit 12c can calculate an input importance $a_i = a_i(x; f)$ of each component of the input by using an existing method as described above.

In the first embodiment, the binding unit 12e calculates a bound importance $\sim a$ as represented by the expression (2) by using a group of the binding coefficients $(c_i^{i'})_{i',i}$, acquired by the coefficient acquisition unit 12d, and outputs the bound importance.

$$\tilde{a}_i(x; f) = \sum_{i'} c_i^{i'} a_{i'}(x; f) \qquad (2)$$

As a method of calculating the input importance $a_i = a_i(x; f)$, for example, there is known a method of using a partial differentiation coefficient (gradient) represented by the expression (3).

$$\frac{\partial f}{\partial x_i}(x) \tag{3}$$

As an improved method for calculating the input importance, a method of integrating the gradient by an appropriate path (Integrated Gradient), a method of smoothing the gradient by noise (SmoothGrad), and Time-Smoothgrad are suggested. Time-Smoothgrad is an improved method compatible with a case in which an input is part of time series data.

Subsequently, the following specifically describes a method of calculating the binding coefficient $(c_i^{i'})_{i,i}$, requested for deriving a bound importance $\sim a_i = \sim a_i(x; f)$. First, as a first example, the following describes an example of obtaining the binding coefficient by using a manifold hypothesis.

In the field of machine learning, there is a case of assuming that lower-dimensional representation satisfying an appropriate hypothesis is present regarding a region that may be taken by the input data. This is called the manifold hypothesis. In a case of this example, for example, it is assumed that an input variable $x = (x_1, ..., x_n) \in R^n$ can be decomposed as represented by the expression (4) by using a low-dimensional latent variable $z = (z_1, ..., z_m) \in R^m$ ($m < n$). It is assumed that $\varepsilon$ represents noise satisfying an appropriate condition.

$$x = \hat{x}(z) + \epsilon \tag{4}$$

Actually, a group of a function z (x) from the input variable to a corresponding latent variable and a function ^x (z) from the latent variable to a reconstructed input variable are learned by the pre-learned relation model. This example describes an example of calculating a group of binding coefficients in a case in which representation by a latent variable of an input variable is given, that is, the group of two functions described above is given in Principal Component Analysis (PCA) or an AutoEncoder (AE).

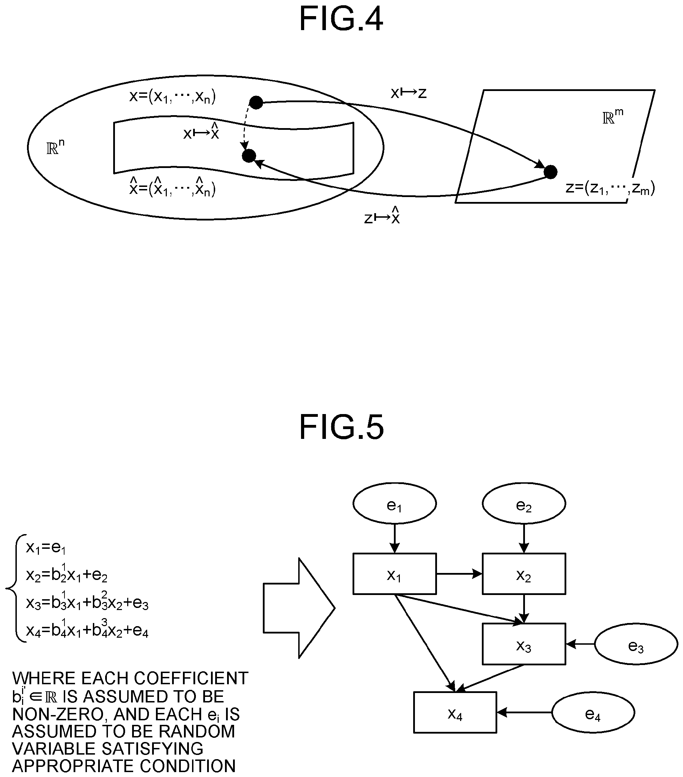

FIG. 4 is a diagram for explaining dimension reduction. For example, in a case of performing dimension reduction using principal component analysis, it is assumed that the latent variable corresponding to the input can be calculated by the expression (5) with a coefficient matrix $W = (w_{ij})_{i,j} \in R^{n \times m}$, and it is assumed that the input reconstructed from the latent variable can be calculated by the expression (6).

$$z_j(x; W) = \sum_i x_i w_{ij} \tag{5}$$

$$\hat{x}_i(z; W) = \sum_j z_j w_{ij} \tag{6}$$

At this point, for example, the coefficient acquisition unit 12d calculates the binding coefficient as follows. A partial differentiation coefficient $\partial^{\hat{}} x_{i'}/\partial x_i$ is assumed to be $c_i^{i'}$. For example, in a case of principal component analysis exemplified herein, $\partial z_j/\partial x_i = w_{ij}$ and $\partial^{\hat{}} x_{i'}/\partial z_j = w_{i'}j$ are satisfied, so that a binding coefficient $c_i^{i'}$ is represented by the expression (7) using a chain rule.

$$c_i^{i'} = \frac{\partial \hat{x}_{i'}}{\partial x_i} = \sum_j \frac{\partial \hat{x}_{i'}}{\partial z_j} \frac{\partial z_j}{\partial x_i} = \sum_j w_{ij} w_{i'j} \tag{7}$$

The binding coefficient $c_i^{i'}$ calculated as described above is interpreted as a degree of variation of the input variable in an input variable $x_i$, direction under restriction of the manifold hypothesis at the time of trying to cause the input variable to vary in an $x_i$ direction, and the binding unit 12e binds the input importance.

This example also corresponds to a case in which dimension reduction is performed on the input data by Latent Semantic Analysis (LSA), Non-negative Matrix Factorization (NMF), and the like, or a case in which a given pre-learned estimation model is a model that can obviously return latent representation to a space of original input data using Linear Discriminant Analysis (LDA), Partial Least Squares (PLS), Canonical Correlation Analysis (CCA), and the like.

Next, the following describes an example of obtaining the binding coefficient by using the causal relation as a second example. When the causal relation between variables of input/output is known, for example, when inference has been performed by appropriate statistical causal analysis, a group of binding coefficients $(c_i^{i'})_{i',i}$ is calculated by using this relation.

In this example, described is an example of calculating the group of the binding coefficients in a case in which the causal relation between input variables is described to be already known by using Structural Equation Modeling (SEM). Specifically, the causal relation between each input variable and output variable is assumed to be unknown.

FIG. 5 is a diagram for explaining an example of the causal relation among input/output variables. The causal relation among the input/output variables is assumed to be given by structural equations illustrated in FIG. 5. In this case, for example, the binding coefficient is calculated as follows.

It is assumed that $c_i^i = 1$ is always satisfied. When $i \neq i'$, for each directed path from $x_i$ to $x_j$, on a directed graph illustrated in FIG. 5, the sum total of values obtained by multiplying a directed side constituting the directed path by a coefficient of a corresponding structural equation is assumed to be $c_i^{i'}$.

For example, directed paths from $x_1$ to $x_4$ on the exemplified directed graph include three paths including $\{(x_1, x_2), (x_2,x_3), (x_3,x_4)\}$, $\{(x_1,x_3), (x_3,x_4)\}$, and $\{(x_1, x_4)\}$, so that the binding coefficient $c_1^4$ is represented by the expression (8).

$$c_1^4 = b_1^2 b_2^3 b_3^4 + b_1^3 b_3^4 + b_1^4 \qquad (8)$$

For example, a directed path from $x_3$ to $x_1$ is not present on the directed graph illustrated in FIG. 5, so that $c_3^1 = 0$ is satisfied.

In this way, the information processing device 10 interprets the calculated binding coefficient $c_i^{i'}$ as a degree of variation of the input variable $x_i$, at the time of operating the input variable $x_i$, and binds the input importance.

As a third example, the following describes an example of not performing binding. Formally, it is assumed that $c_i^i = 1$ and $c_i^{i'} = 0$ $(i \neq i')$ are always satisfied irrespective of a value of an input $x$.

In this case, $\sim a_i$ is represented by the expression (9), and the bound importance is identical to a related input importance. In this sense, the bound importance is a concept truly including the related input importance.

$$\tilde{a}_i = 1 \cdot a_i + \sum_{i' \neq i} 0 \cdot a_{i'} = a_i \qquad (9)$$

Processing procedure of information processing

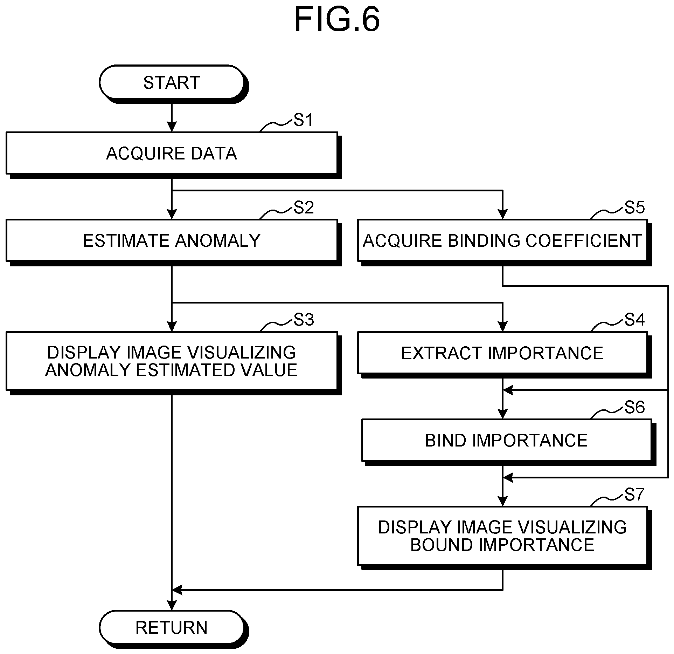

Next, the following describes an example of a processing procedure performed by the information processing device 10. FIG. 6 is a flowchart illustrating an example of the processing procedure of information processing according to the first embodiment.

As exemplified in FIG. 6, when the acquisition unit 12a acquires data (Step S1), the estimation unit 12b inputs the data to the pre-learned estimation model, and estimates, for example, an anomaly after a certain time elapses based on the output data of the pre-learned estimation model (Step S2). The visualization unit 12f displays an image visualizing time series data of the estimated value of the abnormality degree (Step S3).

The importance extraction unit 12c then extracts the input importance with respect to a predetermined output value for each input item at each time by using the input data input to the pre-learned estimation model and the output value from the pre-learned model (Step S4).

The coefficient acquisition unit 12d then inputs a value of each component of the input data to the pre-learned relation model, and acquires a group of values of binding coefficients each indicating the relevance with respect to the value of each component (Step S5). The binding unit 12e calculates the bound importance by applying a corresponding binding coefficient to the input importance extracted by the importance extraction unit 12c (Step S6). The visualization unit 12f then displays an image indicating the bound importance of each input item (Step S7).

Effect of first embodiment

In this way, the information processing device 10 acquires the binding coefficient indicating the relevance among the components of the input data of the pre-learned estimation model, and applies the binding coefficient to the importance to calculate and output the bound importance including the relevance among the input components of the pre-learned estimation model.

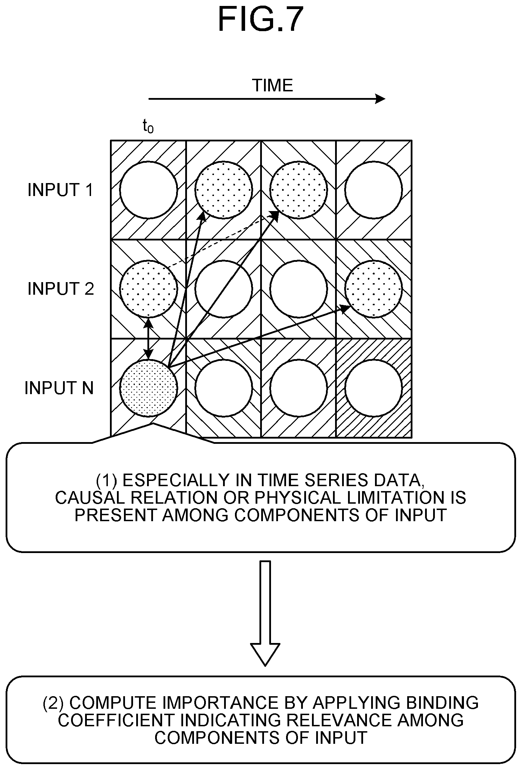

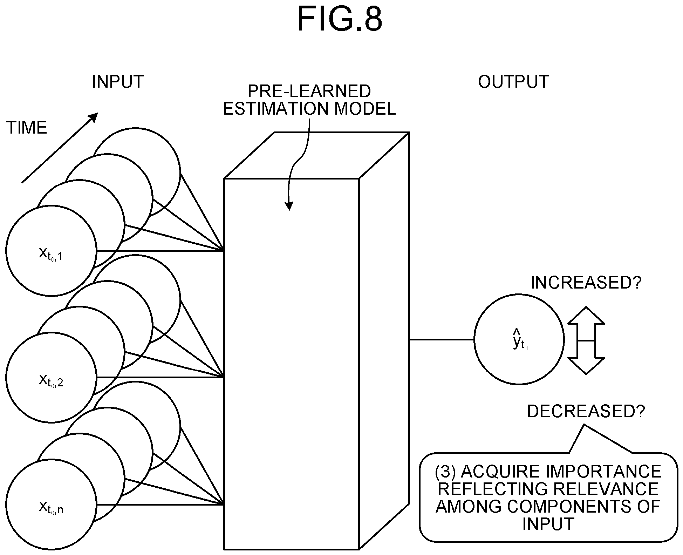

FIG. 7 is a diagram exemplifying the relevance among the components of the input data. FIG. 8 is a diagram exemplifying input/output of data of the pre-learned estimation model. Specifically, in a case of the time series data exemplified in FIG. 7, a causal relation or physical limitation may be present among the components of the input (refer to FIG. 7 (1)). Thus, in the first embodiment, the binding coefficient indicating the relevance among the components of the input data of the pre-learned estimation model is acquired, and the binding coefficient is applied to the input importance to calculate the bound importance (refer to FIG. 7 (2)). In this way, in the first embodiment, even with the pre-learned estimation model that may be called a black box, the bound importance reflecting the relevance among the input components of the model can be obtained (refer to FIG. 8 (3)).

As a result, the monitor of the facility to be monitored can confirm the bound importance to which the relevance among the input components is already applied. Thus, the monitor does not necessarily examine a matching degree between the importance and an experience of the monitor himself/herself related to the correlation and the causal relation among the input components, the examination having been conventionally requested. In other words, the information processing device 10 outputs the bound importance to which the relevance among the input components is already applied, so that a load of interpreting the bound importance on the monitor can be reduced.

In the first embodiment, it is possible to obtain items having a relevance higher than the predetermined value among the input items of the input data of the pre-learned estimation model based on the binding coefficient. In this case, the monitor can easily recognize the relevance among the input components, and in a case of monitoring a production process, the monitor can appropriately grasp influence of the input component that can be operated on the estimated value, and appropriately operate various devices.

Modification

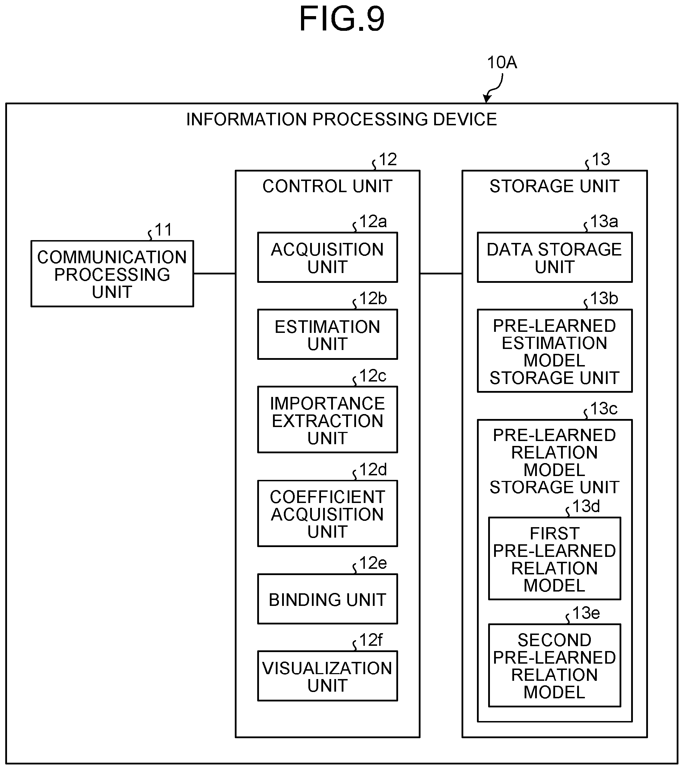

FIG. 9 is a block diagram illustrating a configuration example of an information processing device according to a modification of the first embodiment. In an information processing device 10A illustrated in FIG. 9, the pre-learned relation model storage unit 13c stores a first pre-learned relation model 13d and a second pre-learned relation model 13e.

For example, the first pre-learned relation model 13d has performed learning to calculate the binding coefficient from mapping of dimension reduction. The second pre-learned relation model 13e is a model that learns a causal relation between input variables and calculates the binding coefficient. In a case of acquiring the binding coefficient, the coefficient acquisition unit 12d switches between the first pre-learned relation model 13d and the second pre-learned relation model 13e to be used depending on a monitoring mode.

For example, in a case of a normal mode, the coefficient acquisition unit 12d calculates the binding coefficient by using the first pre-learned relation model 13d. In this case, the information processing device 10A outputs the bound importance including an influence degree from each component of the input data on the output of the pre-learned estimation model. Due to this, the monitor can monitor that the output of the pre-learned estimation model is susceptible to a variation of which component of the input data based on an output result of the information processing device 10A, which is useful for previously finding a risk factor for stable operation in the production process.

In a case of an abnormal mode in which a certain anomaly occurs in the estimated output data, the coefficient acquisition unit 12d switches the model to the second pre-learned relation model 13e to calculate the binding coefficient. In this case, the information processing device 10A outputs the bound importance that is bound by the causal relation between the input variables. Thus, the monitor can monitor a variation that can be caused in a value of the pre-learned estimation model by a device that can be operated in the actual production process among the input components based on the output result of the information processing device 10A. As a result, by controlling the device that can be operated, the monitor can previously examine preventing an anomaly from occurring in the actual production process, or a measure for a case in which an anomaly actually occurs.

System configuration and like

The components of the devices illustrated in the drawings are merely conceptual, and it is not required that they are physically configured as illustrated necessarily. That is, specific forms of distribution and integration of the devices are not limited to those illustrated in the drawings. All or part thereof may be functionally or physically distributed/integrated in arbitrary units depending on various loads or usage states. All or optional part of the processing functions performed by the respective devices may be implemented by a CPU or a GPU and computer programs analyzed and executed by the CPU or the GPU, or may be implemented as hardware using wired logic.

Among pieces of the processing described in the present embodiment, all or part of the pieces of processing described to be automatically performed can be manually performed, or all or part of the pieces of processing described to be manually performed can be automatically performed by using a known method. Additionally, the processing procedures, control procedures, specific names, and information including various kinds of data and parameters described herein or illustrated in the drawings can be optionally changed unless otherwise specifically noted.

**EP 4 040 345 A1**

Computer program

It is also possible to create a computer program describing the processing performed by the information processing device described in the above embodiment in a computer-executable language. For example, it is possible to create a computer program describing the processing performed by the information processing device 10 or the information processing device 10A according to the embodiment in a computer-executable language. In this case, the same effect as that of the embodiment described above can be obtained when the computer executes the computer program. Furthermore, such a computer program may be recorded in a computer-readable recording medium, and the computer program recorded in the recording medium may be read and executed by the computer to implement the same processing as that in the embodiment described above.

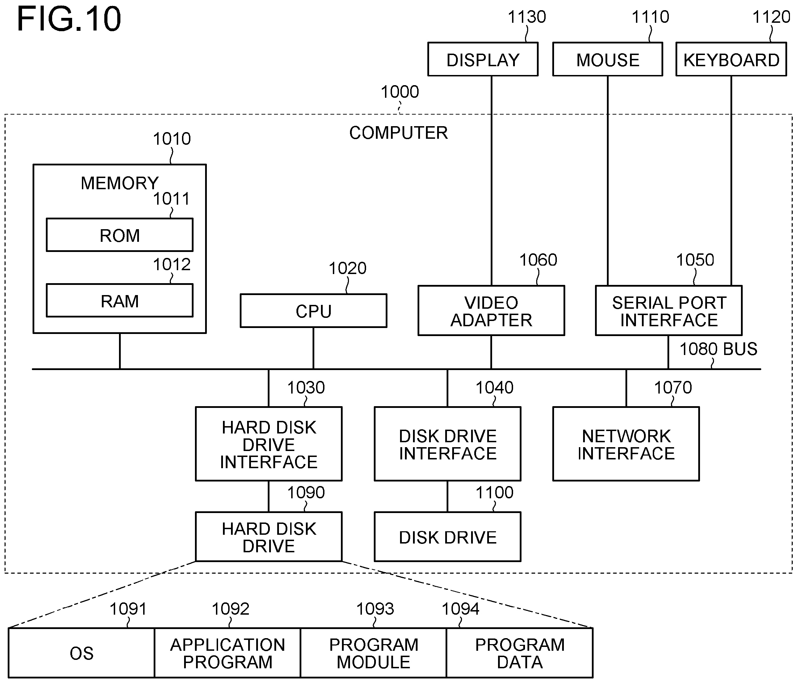

FIG. 10 is a diagram illustrating the computer that executes the computer program. As exemplified in FIG. 9, a computer 1000 includes, for example, a memory 1010, a CPU 1020, a hard disk drive interface 1030, a disk drive interface 1040, a serial port interface 1050, a video adapter 1060, and a network interface 1070, which are connected to each other via a bus 1080.

As exemplified in FIG. 10, the memory 1010 includes a read only memory (ROM) 1011 and a RAM 1012. The ROM 1011 stores, for example, a boot program such as a Basic Input Output System (BIOS). As exemplified in FIG. 9, the hard disk drive interface 1030 is connected to a hard disk drive 1090. As exemplified in FIG. 9, the disk drive interface 1040 is connected to a disk drive 1100. For example, a detachable storage medium such as a magnetic disc or an optical disc is inserted into the disk drive 1100. As exemplified in FIG. 9, the serial port interface 1050 is connected to a mouse 1110 and a keyboard 1120, for example. As exemplified in FIG. 10, the video adapter 1060 is connected to a display 1130, for example.

Herein, as exemplified in FIG. 9, the hard disk drive 1090 stores, for example, an OS 1091, an application program 1092, a program module 1093, and program data 1094. That is, the computer program described above is stored in the hard disk drive 1090, for example, as a program module describing a command executed by the computer 1000.

The various kinds of data described in the above embodiment are stored in the memory 1010 or the hard disk drive 1090, for example, as program data. The CPU 1020 then reads out the program module 1093 or the program data 1094 stored in the memory 1010 or the hard disk drive 1090 into the RAM 1012 as needed, and performs various processing procedures.

The program module 1093 and the program data 1094 related to the computer program are not necessarily stored in the hard disk drive 1090, but may be stored in a detachable storage medium, for example, and may be read out by the CPU 1020 via a disk drive and the like. Alternatively, the program module 1093 and the program data 1094 related to the computer program may be stored in another computer connected via a network (a local area network (LAN), a wide area network (WAN), and the like), and may be read out by the CPU 1020 via the network interface 1070.

The embodiments and the modification thereof described above are included in the technique disclosed herein, and also included in the invention disclosed in CLAIMS and equivalents thereof.

[Explanation of Reference]

10, 10A    INFORMATION PROCESSING DEVICE
11    COMMUNICATION PROCESSING UNIT
12    CONTROL UNIT
12a    ACQUISITION UNIT
12b    ESTIMATION UNIT
12c    IMPORTANCE EXTRACTION UNIT
12d    COEFFICIENT ACQUISITION UNIT
12e    BINDING UNIT
12f    VISUALIZATION UNIT
13    STORAGE UNIT
13a    DATA STORAGE UNIT
13b    PRE-LEARNED ESTIMATION MODEL STORAGE UNIT
13c    PRE-LEARNED RELATION MODEL STORAGE UNIT
13d    FIRST PRE-LEARNED RELATION MODEL
13e    SECOND PRE-LEARNED RELATION MODEL

**Claims**

1. An information processing device comprising:

an acquisition unit configured to acquire a plurality of pieces of data;
a first importance calculation unit configured to input the pieces of data to a model as input data, and in a case of obtaining output data output from the model, calculate an importance of each component of the input data with respect to the output data based on the input data and the output data;
a coefficient acquisition unit configured to acquire a binding coefficient indicating a relevance among components of the input data;
a second importance calculation unit configured to calculate a bound importance obtained by applying the binding coefficient to the importance; and
a creation unit configured to create information indicating the bound importance of each input item.

2. The information processing device according to claim 1, wherein the coefficient acquisition unit acquires the binding coefficient by using a relation model that has learned the relevance among the components of the input data.

3. The information processing device according to claim 1 or 2, wherein the creation unit creates a graph indicating progression of the bound importance of each input item, or a heat map indicating distribution of the bound importance of each input item.

4. The information processing device according to any one of claims 1 to 3, wherein the creation unit obtains items having a relevance higher than a predetermined value among the input items based on the binding coefficient, and creates information indicating the items in association with each other.

5. The information processing device according to any one of claims 1 to 4, wherein

the acquisition unit acquires a plurality of pieces of sensor data acquired in a facility to be monitored,
the first importance calculation unit inputs the pieces of sensor data, as input data, to an estimation model for estimating a state of the facility to be monitored, and in a case of obtaining output data output from the estimation model, calculates an importance for each sensor based on the input data and the output data, and
the coefficient acquisition unit acquires a binding coefficient indicating a relevance among the pieces of sensor data.

6. An information processing method executed by an information processing device, the information processing method comprising:

a step of acquiring a plurality of pieces of data;
a step of calculating by inputting the pieces of data to a model as input data, and in a case of obtaining output data output from the model, calculating an importance of each component of the input data with respect to the output data based on the input data and the output data;
a step of acquiring a binding coefficient indicating a relevance among components of the input data;
a step of calculating a bound importance obtained by applying the binding coefficient to the importance; and
a step of creating information indicating the bound importance of each input item.

7. An information processing program that causes a computer to execute:

a step of acquiring a plurality of pieces of data;
a step of calculating by inputting the pieces of data to a model as input data, and in a case of obtaining output data output from the model, calculating an importance of each component of the input data with respect to the output data based on the input data and the output data;
a step of acquiring a binding coefficient indicating a relevance among components of the input data;
a step of calculating a bound importance obtained by applying the binding coefficient to the importance; and
a step of creating information indicating the bound importance of each input item.

# FIG.1

INFORMATION PROCESSING DEVICE — 10

## CONTROL UNIT — 12

- ACQUISITION UNIT — 12a
- ESTIMATION UNIT — 12b
- IMPORTANCE EXTRACTION UNIT — 12c
- COEFFICIENT ACQUISITION UNIT — 12d
- BINDING UNIT — 12e
- VISUALIZATION UNIT — 12f

## STORAGE UNIT — 13

- DATA STORAGE UNIT — 13a
- PRE-LEARNED ESTIMATION MODEL STORAGE UNIT — 13b
- PRE-LEARNED RELATION MODEL STORAGE UNIT — 13c

COMMUNICATION PROCESSING UNIT — 11

FIG.2

SENSOR AND THE LIKE

DEVICE, REACTOR, AND THE LIKE IN PLANT

(1) ACQUIRE DATA — ANALYSIS WINDOW

A
B
C
D
E

TIME

(5) ACQUIRE BINDING COEFFICIENT

(3) VISUALIZE ANOMALY ESTIMATION

ESTI-MATED VALUE

TIME

(2) ESTIMATE ANOMALY

(4) EXTRACT IMPORTANCE

(7) VISUALIZE IMPORTANCE

IMPORTANCE OF PROCESS DATA WITH RESPECT TO ANOMALY

A
B
C
W1 --- D
W2 --- E

TIME

(6) BIND IMPORTANCE

EP 4 040 345 A1

# FIG.3

# FIG.4

$$x=(x_1,\cdots,x_n)$$

$$x \mapsto z$$

$$x \mapsto \hat{x}$$

$$\mathbb{R}^n$$

$$\mathbb{R}^m$$

$$\hat{x}=(\hat{x}_1,\cdots,\hat{x}_n)$$

$$z \mapsto \hat{x}$$

$$z=(z_1,\cdots,z_m)$$

# FIG.5

$$\begin{cases} x_1=e_1 \\ x_2=b_2^1 x_1+e_2 \\ x_3=b_3^1 x_1+b_3^2 x_2+e_3 \\ x_4=b_4^1 x_1+b_4^3 x_2+e_4 \end{cases}$$

WHERE EACH COEFFICIENT $b_i^{i'} \in \mathbb{R}$ IS ASSUMED TO BE NON-ZERO, AND EACH $e_i$ IS ASSUMED TO BE RANDOM VARIABLE SATISFYING APPROPRIATE CONDITION

$e_1$ $e_2$

$x_1$ $x_2$

$x_3$ $e_3$

$x_4$ $e_4$

# FIG.6

```
                    START
                      │
                      ▼
        ┌─────────────────────────────┐ ～S1
        │        ACQUIRE DATA          │
        └─────────────────────────────┘
                      │
          ┌───────────┴───────────────────────────┐
          ▼                                        ▼
┌──────────────────────┐ ～S2    ┌──────────────────────────────┐ ～S5
│   ESTIMATE ANOMALY    │        │  ACQUIRE BINDING COEFFICIENT  │
└──────────────────────┘        └──────────────────────────────┘
          │                                        │
          │                                        ▼
┌──────────────────────┐ ～S3    ┌──────────────────────────────┐ ～S4
│ DISPLAY IMAGE VISUALIZING      │      EXTRACT IMPORTANCE        │
│ ANOMALY ESTIMATED VALUE │      └──────────────────────────────┘
└──────────────────────┘                         │
          │                                        ▼
          │                        ┌──────────────────────────────┐ ～S6
          │                        │       BIND IMPORTANCE         │
          │                        └──────────────────────────────┘
          │                                        │
          │                                        ▼
          │                        ┌──────────────────────────────┐ ～S7
          │                        │  DISPLAY IMAGE VISUALIZING     │
          │                        │      BOUND IMPORTANCE          │
          │                        └──────────────────────────────┘
          │                                        │
          ▼◄───────────────────────────────────────┘
       RETURN
```

# FIG.7

TIME

$t_0$

INPUT 1

INPUT 2

INPUT N

(1) ESPECIALLY IN TIME SERIES DATA, CAUSAL RELATION OR PHYSICAL LIMITATION IS PRESENT AMONG COMPONENTS OF INPUT

(2) COMPUTE IMPORTANCE BY APPLYING BINDING COEFFICIENT INDICATING RELEVANCE AMONG COMPONENTS OF INPUT

# FIG.8

INPUT

PRE-LEARNED ESTIMATION MODEL

OUTPUT

TIME

$x_{t_0,1}$

$x_{t_0,2}$

$x_{t_0,n}$

INCREASED?

$\hat{y}_{t_1}$

DECREASED?

(3) ACQUIRE IMPORTANCE REFLECTING RELEVANCE AMONG COMPONENTS OF INPUT

# FIG.9

INFORMATION PROCESSING DEVICE — 10A

CONTROL UNIT — 12
- ACQUISITION UNIT — 12a
- ESTIMATION UNIT — 12b
- IMPORTANCE EXTRACTION UNIT — 12c
- COEFFICIENT ACQUISITION UNIT — 12d
- BINDING UNIT — 12e
- VISUALIZATION UNIT — 12f

COMMUNICATION PROCESSING UNIT — 11

STORAGE UNIT — 13
- DATA STORAGE UNIT — 13a
- PRE-LEARNED ESTIMATION MODEL STORAGE UNIT — 13b
- PRE-LEARNED RELATION MODEL STORAGE UNIT — 13c
  - FIRST PRE-LEARNED RELATION MODEL — 13d
  - SECOND PRE-LEARNED RELATION MODEL — 13e

## FIG.10

**INTERNATIONAL SEARCH REPORT**

| International application No. |
|---|
| PCT/JP2020/037029 |

A. CLASSIFICATION OF SUBJECT MATTER
G06N 20/00(2019.01)i
FI: G06N20/00

According to International Patent Classification (IPC) or to both national classification and IPC

B. FIELDS SEARCHED

Minimum documentation searched (classification system followed by classification symbols)
G06N20/00

| Documentation searched other than minimum documentation to the extent that such documents are included in the fields searched | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P, A | JP 2020-095398 A (HITACHI, LTD.) 18 June 2020 (2020-06-18) paragraphs [0061]-[0146] | 1-7 |
| A | US 2019/0279102 A1 (TAZI AI SYSTEMS, INC.) 12 September 2019 (2019-09-12) paragraphs [0171]-[0185] | 1-7 |

☐ Further documents are listed in the continuation of Box C.      ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 December 2020 (14.12.2020) | 22 December 2020 (22.12.2020) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

INTERNATIONAL SEARCH REPORT

Information on patent family members

International application No.

PCT/JP2020/037029

| Patent Documents referred in the Report | Publication Date | Patent Family | Publication Date |
|---|---|---|---|
| JP 2020-095398 A | 18 Jun. 2020 | (Family: none) | |
| US 2019/0279102 A1 | 12 Sep. 2019 | WO 2019/172956 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019067139 A

**Non-patent literature cited in the description**

- **D. BAEHRENS ; T. SCHROETER ; S. HARMELING ; M. KAWANABE ; K. HANSEN ; K. MULLER.** How to Explain Individual Classification Decisions. *Journal of Machine Learning Research,* 2010, vol. 11, 1803-1831
- **D. SMILKOV ; N. THORAT ; B. KIM ; F. VIEGAS ; M. WATTENBERG.** *SmoothGrad: removing noise by adding noise,* 2017
- **M. SUNDARARAJAN ; A. TALY ; Q. YAN.** Axiomatic Attribution for Deep Networks. *ICML,* 2017
- **KIRITOSHI, IZUMITANI.** Time-Smoothgrad: A Method Extracting Time-Varying Attribution for Neural Networks. *JSAI 2019,* 2019